Europäisches Patentamt

European Patent Office

Office européen des brevets

(19)

(11) Veröffentlichungsnummer: **0 025 177**
**A2**

(12) **EUROPÄISCHE PATENTANMELDUNG**

(21) Anmeldenummer: **80105070.9**

(22) Anmeldetag: **26.08.80**

(51) Int. Cl.³: **H 01 L 27/14**
     **H 04 N 3/14**

(30) Priorität: **11.09.79 DE 2936704**

(43) Veröffentlichungstag der Anmeldung:
**18.03.81 Patentblatt 81/11**

(84) Benannte Vertragsstaaten:
**BE FR GB IT NL**

(71) Anmelder: **SIEMENS AKTIENGESELLSCHAFT Berlin
und München**
**Postfach 22 02 61**
**D-8000 München 22(DE)**

(72) Erfinder: **Koch, Rudolf, Dipl.-Ing.**
**Nimrodstrasse 42**
**D-8034 Germering(DE)**

(54) **Monolithisch integrierte Schaltung mit einem zweidimensionalen Bildsensor.**

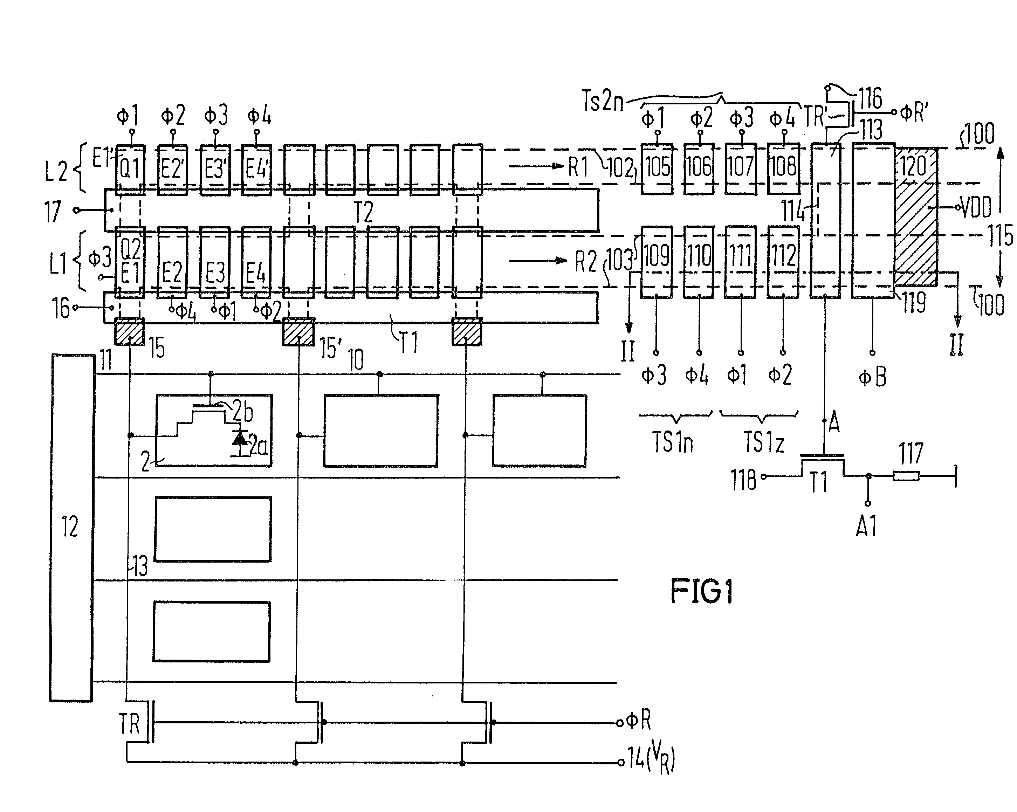

(57) Integrierte Schaltung mit einem zweidimensionalen Bildsensor, bei dem die durch das "fixed pattern noise" gestörten Sensorsignale über die Spaltenleitungen auf ein erstes Auslese-CTD übertragen werden und die Nullsignalladungen anschließend auf ein zweites Auslese-CTD übertragen werden. Angestrebt wird eine einfache, monolithisch integrierbare Lösung für die Differenzbildung zwischen diesen Signalen. Zu diesem Zweck wird ein für beide CTD's gemeinsamer "floating gate"-Differenzausgang vorgesehen. Vorteilhaft ist der geringe zusätzliche Flächenbedarf für die Differenzbildung. Der Anwendungsbereich umfaßt Videokameras. (Figur 1)

EP 0 025 177 A2

./...

FIG1

SIEMENS AKTIENGESELLSCHAFT          Unser Zeichen
Berlin und München                  VPA  79 P 7 1 5 4  EUR


Monolithisch integrierte Schaltung mit einem zweidimensionalen Bildsensor

Die Erfindung bezieht sich auf eine monolithisch integrierte Schaltung mit einem zweidimensionalen Bildsensor nach dem Oberbegriff des Anspruchs 1.

Eine solche integrierte Schaltung ist aus der DE-PS
26 11 771 bekannt. Die differenzbildende Schaltung ist
dort als eine Schaltungsstufe angegeben, die eine
doppelte Abtastung der an einem gemeinsamen Ausgang
beider CTD-Anordnungen abgreifbaren Spannungssignale
durchführt. Eine solche Schaltungsstufe erfordert
einen relativ großen Schaltungsaufwand und läßt sich
nur schwer auf dem Halbleiterkörper mitintegrieren.

Der Erfindung liegt die Aufgabe zugrunde, bei einer
monolithisch integrierten Schaltung mit einem zweidimensionalen Bildsensor der eingangs genannten Art

St 1 Kel / 7.9.79

die erwähnten Schwierigkeiten zu beheben. Diese Aufgabe wird durch die im Anspruch 1 gekennzeichneten Merkmale gelöst.

Andererseits ist aus der DE-OS 28 11 146 ein auf einem Halbleiterkörper integrierter Schaltkreis zur Differenzbildung von elektrischen Ladungen bekannt, bei dem die zu messenden Ladungen in einer ladungsgekoppelten Anordnung Kapazität gebracht und daraus entfernt werden und die entsprechende Potentialdifferenz an der Elektrode gemessen wird. Im Gegensatz zur Erfindung werden die Ladungen jedoch nicht in zwei CTD-Anordnungen verschoben, sondern in einer einzigen.

Der mit der Erfindung erzielbare Vorteil besteht insbesondere darin, daß die differenzbildende Schaltung einen in einfacher Weise zu realisierenden, gemeinsamen Bestandteil beider CTD-Anordnungen darstellt, der nur einen sehr geringen Mehraufwand an Halbleiterfläche erfordert. Damit kann der zweidimensionale Bildsensor einschließlich seiner Ausleseeinrichtungen auf einer wesentlich kleineren Halbleiterfläche realisiert werden, als dies bei der bekannten Schaltung der Fall wäre.

Die Erfindung wird nachfolgend anhand der Zeichnung näher erläutert. Dabei zeigt:

Fig.1 eine nach der Erfindung ausgebildete Schaltung,

Fig.2 einen Querschnitt durch eine Teilschaltung nach Figur 1,

Fig.3 Spannungs-Zeit-Diagramme zur Erläuterung der Schaltung nach Figur 1 und

Fig.4 eine alternative Ausgestaltung einer Teilschaltung von Fig.1.

In Fig.1 ist eine Schaltung schematisch dargestellt, bei der ein zweidimensionaler Bildsensor mit den zugehörigen Auslesevorrichtungen auf einem dotierten Halbleiterkörper 1, z.B. aus p-leitendem Silizium, monolithisch integriert ist. Aus Gründen einer einfachen Darstellung weist der Bildsensor nur neun Sensorelemente auf, die in drei Zeilen und drei Spalten angeordnet sind. Im allgemeinen enthalten Bildsensoren dieser Art jedoch 100 oder mehr Elemente pro Zeile und Spalte. Die Sensorelemente der ersten Zeile sind mit einer gemeinsamen Zeilenleitung 10 verbunden, die an einen Ausgang 11 eines digitalen Schieberegisters 12 geführt ist. Über den Ausgang 11 sind sämtliche Elemente der ersten Zeile gleichzeitig selektierbar. In analoger Weise sind auch die Sensorelemente der übrigen Zeilen über ihre Zeilenleitungen mit Ausgängen des Schieberegisters 12 verbunden, die den Zeilenleitungen individuell zugeordnet sind.

Für jede Sensorspalte ist eine Spaltenleitung, z.B. 13, vorgesehen, die mit allen Sensorelementen dieser Spalte verbindbar ist und über einen mit einer Taktimpulsspannung ØR beschalteten Transistor TR mit einem Anschluß in Verbindung steht, der auf einem Referenzpotential liegt. Die übrigen Spaltenleitungen sind ebenfalls mit den neben ihnen angeordneten Sensorelementen verbindbar und über eigene Transistoren an den Anschluß 14 geführt. Die Spaltenleitung 13 ist weiterhin mit einem an der Grenzfläche des Halbleiterkörpers 1 vorgesehenen Gebiet 15 verbunden, das eine zu diesem entgegengesetzte Leitfähigkeit besitzt. Der neben dem Gebiet 15 liegende Halbleiterbereich wird durch ein mit einem Anschluß 16 versehenes Transfergate T1 überdeckt, das durch eine dünne elektrisch isolierende Schicht, z.B. aus $SiO_2$, von der Grenzfläche des Halbleiterkörpers 1 getrennt ist. Ingleicher Weise sind auch die anderen Spaltenleitungen mit ihnen zugeordneten Halbleitergebieten 15'... verbunden. Das Gate T1 ist neben allen diesen Gebieten angeordnet.

Die Sensorelemente 2 bestehen z.B. aus Fotodioden 2a, wie in Fig.1 angedeutet ist. Dabei ist jede Fotodiode über die Source-Drain-Strecke eines Feldeffekttransistors 2b mit der zugehörigen Spaltenleitung 13 verbunden, während das Gate von 2b an der entsprechenden Zeilen – leitung liegt. Andererseits können die Sensorelemente 2 auch aus MIS-Kondensatoren bestehen oder als CID-Sensorelemente ausgebildet sein, die jeweils zwei nebeneinander liegende MIS-Kondensatoren aufweisen. All diese Arten von Sensorelementen sind an sich bekannt, so z.B. aus P.G.Jespers et al.(Hrsg.); Solid State Imaging; Noordhof Int. Publishing, Leyden, Niederlande und s.Ohta . et al.; "A 1024 element linear CCD und sensor with a new photodiode structure", Proc.IEDM'77, Washington, pp.538 - 541. Werden Fotodioden als Sensoren verwendet, so ergibt sich der Vorteil einer gleichmäßigen spektralen Empfindlichkeit.

Der Halbleiterbereich neben dem Transfergate T1 ist durch eine Reihe von Transferelektroden E1...E4 usw. einer ersten CTD-Anordnung L1 überdeckt, die ebenfalls auf der dünnen Isolierschicht angeordnet sind. Sie weisen Anschlüsse auf, die mit Taktimpulsspannungen $\emptyset$ bis $\emptyset4$ beschaltet sind. Jeder Spaltenleitung sind vier dieser Transferelektroden zugeordnet. Neben der von dem Transfergate abgewandten Seite der CTD-Anordnung L1 ist dem Transfergate abgewandten Seite der CTD-Anordnung L1 ist ein Transfergate T2 vorgesehen, das einen Anschluß 17 aufweist. Weitere Transferelektroden E1' bis E4' gehören zu einer CTD-Anordnung L2, die parallel zu L1 liegt.

Der vorstehend beschriebene Schaltungsteil, der aus dem Bildsensor und einem Ausleseteil mit zwei CTD-Schieberegistern besteht, ist aus der DE-PS 26 11 771 bekannt. Das Auslesen von Bildinformationen, das dort in Verbindung mit den Figuren 1 bis 5 erläutert wird, beginnt zunächst mit einem Rücksetzen der Sensorelemente einer Zeile auf das Referenzpotential $V_R$. Zu diesem Zweck werden die Transistoren 2b und TR in den leitenden Zustand geschaltet. Anschließend werden die Transistoren TR wieder gesperrt, so daß die Spaltenleitungen von äußeren Potentialen freigeschaltet sind, d.h. sich im Zustand des "floating" befinden. In den Sensorelementen sammeln sich optisch erzeugte Ladungen an, die das zunächst $V_R$ entsprechende Potential auf den Spaltenleitungen absenken, solange sich der Transistor 2b im leitenden Zustand befindet. Die Zeitspanne zwischen dem Sperren von TR und dem Sperren von 2b wird als Integrationszeit bezeichnet. Die in dieser Zeitspanne erfolgte Potentialabsenkung, die über die Spaltenleitung 13 auch das Gebiet 15 beeinflußt, bewirkt hierdurch einen Ladungstransport aus dem Gebiet 15 über das eine Potentialbarriere aufbauende Transfergate T1, das zu diesem Zweck auf eine hinreichend kleine, konstante Spannung gesetzt wird, in das Halbleitergebiet unterhalb von E1. Von dort werden die Ladungsträger beim Auftreten eines Impulses am Anschluß 17 von T2 in den Halbleiterbereich unterhalb der Transferelektrode E1' transportiert. Die dorthin gelangten Ladungsträger

79 P 7 1 5 4 EUR

bilden ein Ladungspaket Q1.

Anschließend werden die gleichen Sensorelemente, also im betrachteten Fall die an der Zeilenleitung 10 liegenden, einem zweiten Auslesevorgang unterzogen, wobei der Unterschied zu dem ersten Auslesevorgang darin besteht, daß möglichst wenig optisch erzeugte Ladungsträger in den Sensorelementen gesammelt werden. Das kann z.B. durch eine sehr kurze Bemessung der Integrationszeit geschehen. Die hierbei doch erhaltenen Signale sind ausschließlich auf störende Einflüsse innerhalb des Bildsensors zurückzuführen, wie z.B. auf Kennwertedifferenzen einzelner Teilschaltungen gegeneinander, auf Einkopplungen der zum Betrieb verwendeten Taktimpulsspannungen, usw. Derartige Störungen werden auch als "fixed pattern noise" bezeichnet. Die hiervon herrührenden Ladungen werden nun in der beschriebenen Weise in Ladungspakete Q2 umgesetzt, die unterhalb von E1 und weiteren Transferelektroden des Schieberegisters L1 gespeichert werden. Die Ladungen Q1 entsprechen den durch die Störungen bzw. Störsignale beeinflußten Sensorsignalen, während die Ladungspakete Q2 den Störungen allein entsprechen und daher auch als Nullsignalladungen bezeichnet werden. Durch die Taktimpulsspannungen $\emptyset 1$ bis $\emptyset 4$ werden die Ladungen Q1 und Q2 in den CTD-Anordnungen schrittweise in Richtung der Pfeile R1 und R2 verschoben.

Da sich Q1 beim Auftreten eines Aktimpulses $\emptyset 4$ bereits unterhalb von E4' befindet, während Q2 zu diesem Zeitpunkt unterhalb von E2 gespeichert ist, sind die Ladungspakete stets soweit räumlich gegeneinander versetzt, daß sich eine Transferelektrode zwischen ihnen befindet. Die n'ten Stufen der beiden CTD-Anordnungen sind in Fig.1 mit TS1n und TS2n angedeutet. Dabei wird unter einer Transferstufe jeweils ein Halbleiterbereich verstanden, der mit Transferelektroden überdeckt ist, die mit sämtlichen dem Ladungstransport dienenden Taktimpulsspannungen beschaltet sind, und zwar in aufsteigender Reihenfolge, also z.B. mit $\emptyset 1$, $\emptyset 2$, $\emptyset 3$ und $\emptyset 4$.

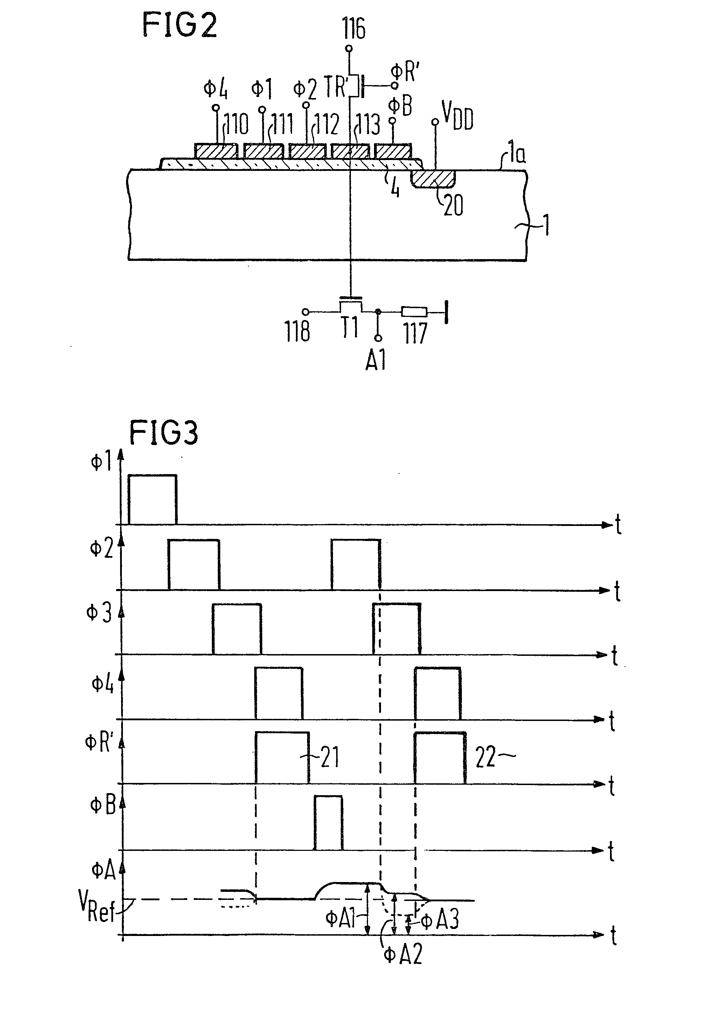

Fig.2 zeigt einen Schnitt durch die Schaltung nach Fig.1 entlang der Linie II - II senkrecht zur Bildebene von Fig.1. In dieser Darstellung ist die dünne elektrisch isolierende Schicht 4 sichtbar, auf der unter anderem die Transferelektroden 111 und 112 plaziert sind.

Auf der isolierenden Schicht 4 ist neben den Transfergates 108 und 112 ein Auskopplungstate 113 vorgesehen. Wie durch die Linie 14 angedeutet ist, vereinigen sich die Übertragungskanäle 102 und 103 unterhalb des Gates 113 zu einem breiteren Übertragungskanal 115. Das Auskopplungsgate 113 ist über einen Schalttransistor TR', dessen Gate mit einer Taktimpulsspannung $\emptyset R'$ beschaltet ist, mit einer Referenzspannungsquelle verbunden, die durch einen auf einem Potential $V_R$ liegenden Anschluß 16 angedeutet ist. Außerdem ist das Gate 113 über einen Anschluß A mit dem Gate eines Transistors T1 verbunden, dessen Source-Drain-Strecke über ein Lastelement 117 mit dem Bezugspotential der Schaltung und mit einem an einer Versorgungsspannung $V_{DD}$ liegenden Anschluß 118 verbunden ist. Das Lastelement kann beispielsweise aus einem Feldeffekttransistor des Verarmungstyps bestehen, dessen Gate mit seinem Sourceanschluß verbunden ist. Der Verbindungspunkt zwischen den Teilen T1 und 117 ist mit dem Schaltungsausgang A1 verbunden. Neben dem Auskopplungsgate 113 sind noch ein mit einer Impulsspannung $\emptyset B$ beschaltetes Gate 119 und ein an der

Grenzfläche 1a liegendes Halbleitergebiet 120 mit einer zu dem Halbleiterkörper 1 entgegengesetzten Leitfähigkeit vorgesehen. Das letztere weist einen Anschluß auf, der an der Versorgungsspannung $V_{DD}$ liegt.

Im Betrieb werden in beiden CTD-Anordnungen unter dem Einfluß der Taktimpulsspannungen $\emptyset 1$ bis $\emptyset 4$ (Fig.3) Ladungspakete $\emptyset 1$ und $\emptyset 2$ in Richtung der Pfeile R1 und R2 schrittweise verschoben. Da die Transferstufen beider CTD-Anordnungen, z.B. TS1n und TS2n, um die Breite zweier Transferelektroden in Längsrichtung gegeneinander versetzt sind, gelangt zunächst beim Auftreten eines Taktimpulses $\emptyset 4$ das im Kanal 102 verschobene Ladungspaket Q1 unter die Elektrode 108, während das im Kanal 103 verschobene Ladungspaket Q2 zu diesem Zeitpunkt unterhalb der Elektrode 110 ist. Durch den Taktimpuls 21 von $\emptyset R$ wird der Transistor TR' in den leitenden Zustand geschaltet, so daß das Auskopplungsgate 113 auf das Potential $V_R$ rückgesetzt wird. Nach Beendigung des Taktimpulses $\emptyset 4$ befindet sich das Ladungspaket Q1 unterhalb von 113, bewirkt jedoch keine Änderung des Potentials $\emptyset A$ an dem gleichfalls auf $V_R$ rückgesetzten Anschluß A, solange der Impuls 21 andauert. Nach Beendigung des Impulses 21 bewirkt ein Impuls $\emptyset B$ den Transport des Ladungspaketes in das Gebiet 120, während gleichzeitig das Potential $\emptyset A$ auf einen durch die Größe des Ladungspakets bestimmten Wert $\emptyset A1$ ansteigt. Nach Beendigung des nachfolgenden Taktimpulses $\emptyset 2$ gelangt dann das zweite Ladungspaket Q2 aus dem Halbleiterbereich unterhalb der Elektrode 112 in den Bereich unterhalb von 113 und verringert entsprechend seiner Größe das Potential $\emptyset A$ auf einen Wert $\emptyset A2$ oder $\emptyset A3$. Die Potentialdifferenz $\emptyset A2-V_R$ bzw. $\emptyset A3-V_R$ entspricht dann der Differenz der in den CTD-Anordnungen L1 und L2 transportierten Ladungspakete Q1 und Q2 nach Betrag und Vorzeichen.

Beim Auftreten des Taktimpulses 22 wird dann ØA wieder
auf $V_R$ rückgesetzt. Aus den genannten Potentialdifferenzen am Anschluß A werden über die als Sourcefolger
geschaltete Stufe 117, 118 entsprechende Ausgangssignale
abgeleitet.

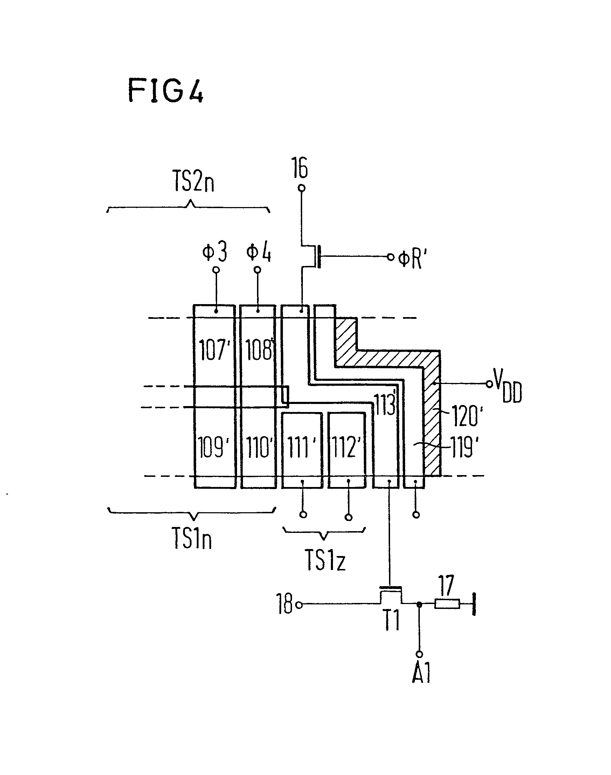

Fig.4 zeigt eine andere nach der Erfindung ausgebildete
Schaltung. Bei dieser liegen die Transferstufen beider
CTD-Anordnungen, z.B. TS1n und TS2n, nebeneinander, wobei TS17 gegenüber der Stufe TS2n in Längsrichtung verschoben ist. In diesem Fall ist das Auskopplungsgate 113'
abgewinkelt, so daß es entsprechend Fig.1 zu den
Elektroden 108' und 112' benachbart angeordnet ist. Das
Gate 119' und das Gebiet 120' sind entsprechend abgewinkelt ausgebildet.

Nach einer Schaltungsvariante können die Übertragungskanäle der beiden CTD-Anordnungen unterhalb des Auskopplungsgate und unterhalb weiterer, diesem in Übertragungsrichtung folgender Transferelektroden oder
Transferstufen voneinander getrennt sein, wie in Fig.1
durch gestrichelte Linien 100 angedeutet ist.
Es entfallen dann die Teile 119 bzw. 119' und 120
bzw. 120'. Hierbei können die Ladungspakete auch
nach der Differenzbildung weitertransportiert und
neuerlich ausgelesen werden, beispielsweise zum Zwecke
einer Korrelationsmessung.

Bei den behandelten Ausführungsbeispielen, bei denen von einem p-leitenden Halbleiterkörper ausgegangen wird, weisen die angegebenen Potentiale und Spannungen gegenüber dem Bezugspotential der Schaltung, auf dem der Halbleiterkörper 1 liegt, jeweils positive Vorzeichen auf. Werden die Leitfähigkeitstypen der einzelnen Halbleitergebiete durch die jeweils entgegengesetzten ersetzt, so kehren sich auch die Vorzeichen der Spannungen und Potentiale um.

Obwohl die CTD-Anordnungen der angegebenen Ausführungsbeispiele als SCCD-Anordnungen (Surface-Charge-Coupled Device) ausgebildet sind, kann die Erfindung mit bekannten CTD-Anordnungen beliebiger Art ausgeführt werden, wie sie z.B. in dem Buch von Séquin und Tompsett "Charge Transfer Devices", Academic Press, New York, 1975, auf den Seiten 1 bis 18 beschrieben sind. Die CTD-Anordnungen können dabei entsprechend ihrem Aufbau im 2-, 3-, 4- oder Mehrphasenbetrieb arbeiten.

4 Patentansprüche
4 Figuren

<u>Patentansprüche</u>

1. Monolithisch integrierte Schaltung mit einem zweidimensionalen Bildsensor, bei der die Sensorelemente auf einem dotierten Halbleiterkörper in Zeilen und Spalten angeordnet sind, bei der jeder Spalte eine Spaltenleitung zugeordnet ist, die eine Ausleseleitung für die Sensorsignale der in dieser Spalte liegenden Sensorelemente darstellt, bei der jede Spaltenleitung über Schaltelemente mit dem Eingang einer Transferstufe einer ersten CTD-Anordnung und mit dem Eingang einer Transferstufe einer zweiten CTD-Anordnung verbindbar ist, und bei der die Ausgänge beider CTD-Anordnungen mit einer differenzbildenden Schaltung verbunden sind, die jeweils die Differenz aus zwei von ein und derselben Spaltenleitung nacheinander in beide CTD-Anordnungen eingegebenen Sensorsignale bildet und als Ausgangssignal abgibt, dadurch g e k e n n z e i c h n e t , daß ein durch eine dünne isolierende Schicht (4) von dem Halbleiterkörper (1) getrenntes Auskopplungsgate (113) vorgesehen ist, daß die Übertragungskanäle (102, 103) beider CTD-Anordnungen (L1, L2) unterhalb des für beide gemeinsamen Auskopplungsgate (113) verlaufen und daß das Auskopplungsgate (113) einerseits über einen ersten Schalttransistor (TR') mit einer Referenzspannungsquelle (116) und andererseits mit dem Schaltungsausgang (A1) beschaltet ist.

2. Integrierte Schaltung nach Anspruch 1, dadurch gekennzeichnet, daß sich an das Auskopplungsgate (113) ein mit einer Konstantspannung beschaltetes, durch eine dünne isolierende Schicht (4) von dem Halbleiterkörper (1) getrenntes Gate (119) und ein zu diesem
benachbartes Halbleitergebiet (120) mit einem zu dem
Halbleiterkörper (1) entgegengesetzten Leitfähigkeitstyp anschließen und daß sich die beiden Übertragungskanäle (102, 103) unterhalb des Auskopplungsgate (113)
zu einem für beide CTD-Anordnungen (L1, L2) gemeinsamen
Übertragungskanal (115) vereinigen.

3. Integrierte Schaltung nach Anspruch 1, dadurch gekennzeichnet, daß die Übertragungskanäle (102, 103)
der beiden CTD-Anordnungen unterhalb des Auskopplungsgate (113) und unterhalb der diesem in Übertragungsrichtung folgenden Transferelektroden voneinander getrennt sind.

4. Integrierte Schaltung nach einem der vorhergehenden
Ansprüche, dadurch gekennzeichnet, daß die Sensorelemente
(2) aus Fotodioden bestehen.

FIG1

0025177

FIG2

116

$\phi R'$

$\phi 4$ $\phi 1$ $\phi 2$ TR' $\phi B$ $V_{DD}$

110 111 112 113

1a

4 20

1

118 T1 117

A1

FIG3

$\phi 1$ t

$\phi 2$ t

$\phi 3$ t

$\phi 4$ t

$\phi R'$ 21 22 t

$\phi B$ t

$\phi A$

$V_{Ref}$

$\phi A1$ $\phi A3$ t

$\phi A2$

FIG 4